# EUROPEAN PATENT APPLICATION

(11) **EP 2 431 436 A1**
(43) Date of publication of application: **21.03.2012**
(21) Application number: 11179526.6
(22) Date of filing: 31.08.2011
(51) Int. Cl.: C09J 7/02, H01L 31/048

(54) **Base material film for back sheet of solar cell and method of manufacturing the same**

(30) Priority: 17.09.2010 JP 2010209972; 21.10.2010 JP 2010236844
(71) Applicant: Fujifilm Corporation, Minato-ku Tokyo (JP)
(72) Inventor: Imamura, Naoya, Kanagawa (JP); Hatakeyama, Akira, Kanagawa (JP); Tanaka, Shinji, Kanagawa (JP)
(74) Representative: HOFFMANN EITLE

(57) **Abstract**

The present invention provides a base material film for a back sheet of a solar cell, the base material film including: a sheet-shaped support containing a first polymer; and an easy-adhesive layer provided on at least one side of the support, the easy-adhesive layer including an inorganic fine particle and a binder including an acrylic resin crosslinked by a compound having an oxazoline group, and a method of manufacturing a base material film for a back sheet of a solar cell, the method including: coating a liquid including a compound having an oxazoline group, an acrylic resin, and an inorganic fine particle on at least one side of a sheet-shaped support containing a first polymer to form a coating film; and heating the coating film such that the acrylic resin is crosslinked by the compound having the oxazoline group.

## Description

### BACKGROUND OF THE INVENTION

### Field of Invention

The present invention relates to a base material film for a back sheet of a solar cell and a method of manufacturing the same.

### Description of the Related Art

Solar cell modules have a structure such that a solar cell is protected by two protective members each in the form of a sheet, and between the protective members, the solar cell is sealed with a sealing material. One of the protective members is a front face member which is provided at the side of a light receiving face that receives the sun light, and the other protective member is a so-called back sheet which is provided at the rear side of the solar cell. The front face member is generally a glass, and an ethylene-vinyl acetate copolymer (EVA) is generally used as the sealing material.

Back sheets have a function of preventing permeation of moisture from the rear face of a solar cell module. A glass or the like has conventionally been used for the back sheet, but from the viewpoints of costs, a polymer represented by a resin is recently being used. Further, the back sheet is required not only to be a mere polymer sheet but also to have adhesive performance to strongly adhere to the sealing material.
Regarding this, a technique of providing an easy-adhesive layer on an outermost layer of a back sheet is known. For example, a technique of coating a hardener on a polyester support, or a technique of providing a thermal adhesive layer has been disclosed. (for example, Japanese Patent Application Laid-Open (JP-A) Nos. 2006-152013 and 2003-060218).

A back sheet of a solar cell is usually produced by laminating plural films having different functions, and since a base material film which is used as a core material is adhered to other films or a sealing material, the base material film is required to have good adhesive property.
For example, adhesion between films can be obtained by performing a surface treatment such as a corona treatment or a flame treatment to the surfaces of the films. However, there is a case in which the adhesion is deteriorated by aging-induced changes after the treatment or a case in which the surface treated film roll causes blocking.

The present invention aims to provide a base material film for a back sheet of a solar cell, the base material film having high adhesion to the support and including an easy-adhesive layer having excellent resistance to climate, and a method of manufacturing the same.

### SUMMARY OF THE INVENTION

According to one aspect of the present invention, there is provides a base material film for a back sheet of a solar cell, the base material film including:
a sheet-shaped support containing a first polymer; and
an adhesive layer (hereinafter referred to as "easy-adhesive layer") provided on at least one side of the support, the easy-adhesive layer including an inorganic fine particle and a binder containing an acrylic resin crosslinked by a compound having an oxazoline group.
According to another aspect of the present invention, there is provides a method of manufacturing a base material film for a back sheet of a solar cell, the method including:
   coating a liquid including a compound having an oxazoline group, an acrylic resin, and an inorganic fine particle on at least one side of a sheet-shaped support containing a first polymer to form a coating film; and
   heating the coating film such that the acrylic resin is crosslinked by the compound having the oxazoline group.

### BRIEF DESCRIPTION OF THE DRAWINGS

Fig. 1 is a cross-sectional diagram schematically showing one example of the configuration of a solar cell module equipped with a base material film for a back sheet according to the present invention.
Fig. 2 is a cross-sectional diagram schematically showing a configuration of a base material film for a back sheet according to a first exemplary embodiment.
Fig. 3 is a cross-sectional diagram schematically showing a configuration of a base material film for a back sheet according to a second exemplary embodiment.
Fig. 4 is a diagram schematically showing one example of a configuration of the manufacturing equipment for manufacturing a base material film for a back sheet.

### DETAILED EXPLANATION OF THE INVENTION

According to the present invention, a base material film for a back sheet of a solar cell, the base material film having high adhesion to the support and including an easy-adhesive layer having excellent resistance to climate, and a method of manufacturing the same may be provided.

Hereinafter, exemplary embodiments of the present invention will be described with reference to the accompanying drawings. It should be appreciated, however, that the following exemplary embodiments are each one example of the present invention and that the present invention is not limited to these exemplary embodiments. Further, in the present specification, the expression "from A to B" which shows the numeric value range is used to indicate that the lower limit value represented by A and the upper limit value represented by B are both included in the range.

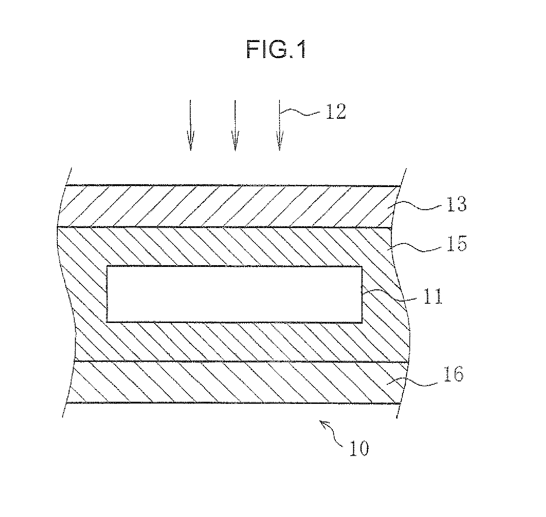

As shown in Fig. 1, a solar cell module (hereinafter, merely referred to as a module) is generally equipped with a solar cell (hereinafter, referred to as a cell) 11, a front face member 13 provided at the front face side of the cell 11 so as to protect the light receiving face side of the cell 11, a back sheet 16 as a rear face member that protects the rear face side of the cell 11, and a sealing material 15 that seals the cell 11 between the front face member 13 and the back sheet 16. In this manner, the cell 11 is held between the front face member 13 and the back sheet 16 by the sealing material 15. Two or more of such modules 10 are combined with each other to form a solar cell panel, and used.

The base material film for a back sheet of a solar cell according to the present invention constitutes a part of a back sheet of such a solar cell and has a sheet-shaped support containing a first polymer, and an easy-adhesive layer disposed on at least one side of the support, the easy-adhesive layer including an inorganic fine particle and a binder including an acrylic resin crosslinked by a compound having an oxazoline group.

### First Exemplary Embodiment

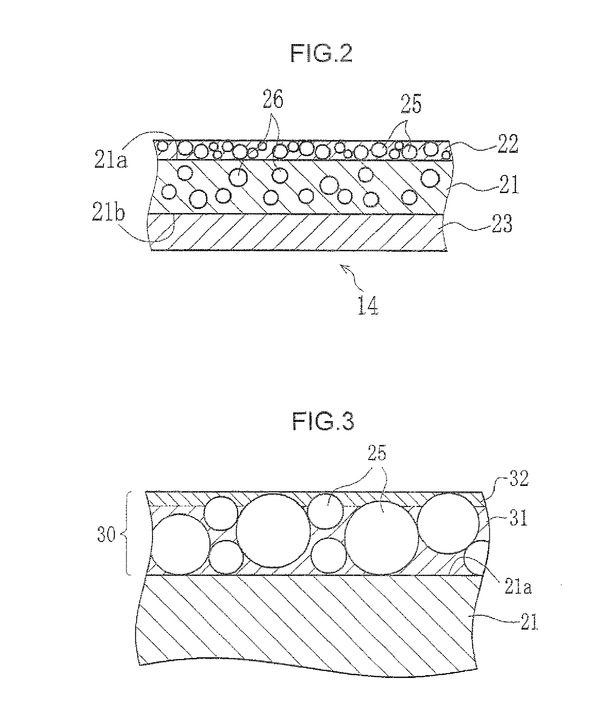

As shown in Fig. 2, a base material film 14 for a back sheet of a solar cell according to the first exemplary embodiment has a sheet-shaped support 21 formed from a first polymer, and an easy-adhesive layer 22 provided on one side 21 a of the support 21 and having a function to adhere the support 21 to the sealing material 15.
Further, a barrier sheet 23 that protects the support 21 and the easy-adhesive layer 22 from an environment of high-humidity and high-temperature may be provided on the face 21 b at the opposite side of the support 21.

### Support

The support 21 is prepared by molding the first polymer to form a sheet in accordance with a melt film-forming method or a solution film-forming method. The first polymer to be used for the support 21 is not particularly limited, but is preferably a fluorine resin or polyester. Among them, polyester is more preferable from the viewpoints of costs, as well as adhesive strength with respect to the sealing material 15 by means of the easy-adhesive layer 22, and maintaining the adhesive strength even in an environment of heat and humidity.

The polyester is a linear saturated polyester which is synthesized by using an aromatic dibasic acid or a derivative thereof having a nature of forming an ester (hereinafter, referred to as an ester forming property) and a diol or a derivative thereof having an ester forming property. Specific examples of such polyester include polyethylene terephthalate (PET), polyethylene isophthalate, polybutylene terephthalate (PBT), and polyethylene-2,6-naphthalate (PEN).

The polyester may be a homopolymer of the above polyester or may be a copolymer. Further, a small amount of other kind of polymer, for example, polyimide or the like, may be blended with the above polyester.

Among the polyesters described above, PET and PEN are particularly preferable from the viewpoints of a balance between a mechanical property and a cost.

In a case in which the first polymer is polyester, the support 21 is preferably a biaxially stretched film which is prepared through the following procedure. Namely, polyester is melt-extruded in the form of a film, then cooled and solidified on a casting drum to obtain an unstretched film. This unstretched film is subjected to a longitudinal direction stretching process of stretching the film once or two or more times in the longitudinal direction under the temperature condition of from the temperature of Tg (°C) to the temperature of Tg + 60 (°C). Then, after the longitudinal direction stretching process, the film is subjected to a cross direction stretching process of stretching the film in the cross direction at a temperature of from the temperature of Tg (°C) to the temperature ofTg + 60 (°C). Note that, in the longitudinal direction stretching process, the film is preferably stretched such that the length after stretching becomes from 3 times to 6 times the length before stretching, and in the cross direction stretching process, the film is preferably stretched such that the width after stretching becomes from 3 times to 5 times the width before stretching in the cross direction. Furthermore, the support 21 may be subjected to a heat treatment at a temperature of from 180°C to 230°C for 1 sec to 60 sec in advance.

The thickness of the support 21 is preferably in a range of from 25 µm to 300 µm. When the thickness is within this range, it is preferable from the viewpoint of a balance between a mechanical strength and a cost.

The support 21 may include fine particles 26. When the support 21. includes fine particles 26, the sun light 12 can be reflected at the interfaces between the fine particles 26 and the first polymer in the support 21, and the reflected light can be introduced to the cell 11. In a case where the first polymer is polyester, a white support 21 may be prepared by adding thereto fine particles 26, and in this case, light fastness of the support 21 can be improved.

The fine particles 26 are preferably so-called inorganic fine particles formed from an inorganic substance. As the inorganic substance, barium sulfate, titanium dioxide, or the like can be used, and among them, titanium dioxide TiO₂ is more preferable. When polyester is used as the first polymer and the fine particles are formed from titanium dioxide, the effect of prevention of reduction in adhesive property in terms of the adhesive force between the easy-adhesive layer 22 and the support under an environment of heat and humidity may be more remarkably realized. Further, among the titanium dioxide, a rutile type titanium dioxide is particularly preferable.

The average particle diameter of the fine particles 26 is preferably in a range of from 0.1 µm to 5.0 µm. When the average particle diameter is within this range, the problem of falling-off of the fine particles 26 from the first sheet face 21 a before the application or during the formation of the easy-adhesive layer 22, or falling-off of the fine particles 26 from the second sheet face 21 b before the application or during the formation of the barrier sheet 23 may be less likely to occur.

The above average particle diameter of the fine particles 26 is a value measured in accordance with the transmission electron microscopy described below. This transmission electron microscopy is as follows. First, the cross section of the back sheet base material film including the fine particles 26 or the cross section of the support 21 is observed using a transmission type electron microscope, and a photograph of the cross section is obtained. In the photograph of the cross section, twenty particles of the fine particles 26 are arbitrary selected, and with regard to each of the selected fine particles 26, the length of the major axis and the length of the minor axis of the particle are measured. Note that, the cross section of each of the fine particles 26 is approximated to an ellipse, and the length of the major axis and the length of the minor axis of this ellipse are measured. The average value of the length of the major axis and the length of the minor axis is used as the particle diameter of the fine particle 26. The average particle diameter of the twenty particles of fine particles 26 is determined, and the average value is used as the average particle diameter of the fine particles 26. It should be noted that a scanning type electron microscope may be used instead of using a transmission type electron microscope.

Further, the fine particles 26 are preferably those which have been subjected to adjustment of particle diameter and removal of coarse particles having a particle diameter bigger than the particle diameter described above in advance, through a refining process and a classification process. As an industrial means for the refining process, a milling means, for example, a jet mill or a ball mill, is applicable, and as a classification means, for example, dry or wet centrifugation is applicable.

The amount of the fine particles 26 is preferably from 5 parts by mass to 40 parts by mass, and more preferably from 10 parts by mass to 35 parts by mass, with respect to 100 parts by mass of the first polymer. When the amount of the fine particles 26 is within this range of mass proportion, the fine particles 26 do not fall off from the support 21, and the mechanical strength of the support 21 does not deteriorate, and a sufficient reflection performance can be obtained more surely.

The method of adding the fine particles 26 to the support 21 is not particularly limited, and for example, the following methods (1) to (3) may be used.
(1) A method of adding the fine particles 26 before completion of transesterification or esterification at the time of synthesizing polyester; or a method of adding the fine particles 26 before initiation of a polycondensation reaction, and molding the obtained polyester to form a sheet.
(2) A method of adding the fine particles 26 to polyester, melt-kneading the polyester to which the fine particles 26 have been added, and molding the kneaded material to form a sheet.
(3) A method of preparing a master pellet containing a large amount of fine particles 26 at the time of melt-kneading polyester, mixing the obtained master pellet with a polyester pellet that does not contain the fine particle 26, melt-kneading the mixture, and molding the kneaded mixture to form a sheet.

### Easy-Adhesive Layer

The easy-adhesive layer 22 is provided on one side of the support 21, and contains an inorganic fine particle and a binder containing an acrylic resin crosslinked by a compound having an oxazoline group (hereinafter, referred to as an oxazoline compound). The easy-adhesive layer 22 can be formed by coating a coating liquid containing the inorganic fine particle 25, the oxazoline compound, and the acrylic resin each at a predetermined amount, on one side 21a of the support 21.

### Oxazoline Compound

When the coating liquid is coated and solidified to form an easy-adhesive layer 22, the acrylic resin is in a state that has been crosslinked by the oxazoline compound. In other words, the oxazoline compound functions as a crosslinking agent that crosslinks the acrylic resin. The oxazoline compound is ring-opened when the oxazoline compound crosslinks the acrylic resin.

The content of the structural moiety derived from the oxazoline compound in the easy-adhesive layer 22 is preferably from 5% by mass to 50% by mass, and more preferably from 10% by mass to 40% by mass, with respect to the structural moiety derived from the acrylic resin, from the viewpoint of improvement in resistance to heat and humidity. It is preferable to add the oxazoline compound such that the mass proportion of the oxazoline compound to the acrylic resin is within the above range, at the time of preparing the coating liquid for forming the easy-adhesive layer 22.

The oxazoline compound is preferably any one of a monomer or an oligomer thereof. When a monomer or oligomer of an oxazoline compound is contained, as compared with the case of containing a polymer of an oxazoline compound, the molecular chains of the acrylic resin are more densely crosslinked with each other and, as a result, the network structure of the molecules in the easy-adhesive layer 22 becomes finer, and therefore, there is no unevenness in the adhesive strength and, as a result, the adhesive strength is less likely to be lowered even if the easy-adhesive layer has been exposed to an environment of heat and humidity.

In order to obtain a finer network structure in the easy-adhesive layer 22, it is more preferable that the number of oxazoline groups in a molecule is 2 or more.

Examples of the oxazoline compound, which may be used, include
2-vinyl-2-oxazoline, 2-vinyl-4-methyl-2-oxazoline, 2-vinyl-5-methyl-2-oxazoline,
2-isopropenyl-2-oxazoline, 2-isopropenyl-4-methyl-2-oxazoline,
2-isopropenyl-5-ethyl-2-oxazoline, 2,2'-bis-(2-oxazoline), 2,2'-methylene-bis-(2-oxazoline),
2,2'-ethylene-bis-(2-oxazoline),2,2'-trimethylene-bis-(2-oxazonne),
2,2'-tetramethylene-bis-(2-oxazoline), 2,2'-hexamethylene-bis-(2-oxazoline),
2.2'-octamethylene-bis-(2-oxazoline), 2,2'-ethylene-bis-(4,4'-dimethyl-2-oxazoline),
2,2'-p-phenylene-bis-(2-oxazoline), 2,2'-m-phenylene-bis-(2-oxazoline),
2,2'-m-phenylene-bis-(4,4'-dimethyl-2-oxazoline), bis-(2-oxazolinylcyclohexane)sulfide, and
bis-(2-oxazolinylnorbornane)sulfide. In addition, oligomers or copolymers obtained by polymerization using these compounds may also be used.

As the oxazoline compound, commercially available products can be also used, and examples thereof include EPOCROS K2010E, K2020E, K2030E, WS500, and WS700 (all trade names, manufactured by NIPPON SHOKUBAI CO., LTD.)

### Acrylic Resin

An acrylic resin is contained as a main component of a so-called binder that holds the inorganic fine particles 25 in the easy-adhesive layer 22, and is crosslinked by an oxazoline compound. Generally, polyurethane, polyester, polyolefin, or the like is also used as the binder that constitutes the easy-adhesive layer 22. However, when an acrylic resin is used and the acrylic resin is crosslinked by the oxazoline compound, water resistance is enhanced, and an easy-adhesive layer having excellent resistance to climate can be formed.
The molecular weight of the acrylic resin is not particularly limited. For example, an acrylic resin having a weight average molecular weight (Mw) of from about thousands to about tens of thousands may be preferably used.
It is preferable that the acrylic resin has a carboxylic group in order to subject the acrylic resin and the oxazoline compound to a crosslinking reaction. Examples of such a carboxylic acid include copolymers of acrylic acid and acrylic acid ester. Examples of the acrylic acid ester, which can be used, include methyl acrylate, ethyl acrylate, propyl acrylate, butyl acrylate, ethylhexyl acrylate, cyclohexyl acrylate, phenyl acrylate, and benzyl acrylate. As a commercially available acrylic resin, an acrylic acid copolymer resin such as JURYMER ET-41 0 (trade name, TOAGOSEI CO., LTD.) or the like can be used.

### Inorganic Fine Particle

The inorganic fine particle 25 contained in the easy-adhesive layer 22 gives suitable rigidity to the easy-adhesive layer 22, makes it possible to disperse the stress with respect to the peeling force from the outside, and imparts good adhesion to a surface of a support such as PET.
The inorganic substance that constitutes the inorganic fine particle 25 is preferably an inorganic compound. The inorganic compound is preferably silicon oxide (silica, SiO₂) tin oxide SnO₂ zirconium oxide ZrO₂ aluminum oxide Al₂O₃, calcium carbonate, magnesium oxide, or magnesium carbonate. Among them, oxides of at least one selected from the group consisting of silicon, tin, zirconium, and aluminum, namely, SiO₂, SnO₂, ZrO₂, and Al₂O₃ are more preferable. When an inorganic fine particle 25 formed from the above metal oxide is used, the effect of adhesion to the support is more remarkably obtained. From the viewpoint of obtaining this effect, it is particularly preferable that the inorganic substance that constitutes the inorganic fine particle contains either SiO₂ or SnO₂.

The primary particle diameter of the inorganic fine particle 25 is preferably in a range of from 10 nm to 300 nm, and particularly preferably from 20 nm to 150 nm, from the viewpoint of obtaining a homogeneous adhesive strength. Further, the particle diameters of the inorganic fine particles 25 may be not uniform, as shown in Fig. 2. Note that, in Fig. 2, the inorganic fine particles 25 are drawn big with exaggeration. The shape of the inorganic fine particle 25 may be spherical, amorphous, or needle-like, and these may be mixed with each other.

The content of the inorganic fine particles 25 is preferably from 20% by volume to 120% by volume, and more preferable from 20% by volume to 80% by volume, with respect to the binder containing the acrylic resin crosslinked by the oxazoline compound. When the content of the inorganic fine particles 25 is within the above range, the adhesive strength of the easy-adhesive layer 22 is less likely to be lowered even if the easy-adhesive layer has been exposed to an environment of heat and humidity.

### Thickness

The thickness of the easy-adhesive layer 22 is preferably from 0.03 µm to 1 µm, and more preferably from 0.05 µm to 0.8 µm. When the thickness is 1 µm or less, the costs may be maintained low and when the thickness is 0.03 µm or more, the adhesive strength of the easy-adhesive layer is less likely to be lowered even if the easy-adhesive layer is placed in an environment of heat and humidity. The thickness of the easy-adhesive layer 22 may be determined according to the particle diameter or the like of the inorganic fine particle 25. Thus, the smaller particle diameter of the inorganic fine particles 25 is used, the thinner the thickness may be made.

### Second Exemplary Embodiment

As shown in Fig. 3, in the base material film for a back sheet of a solar cell according to the second exemplary embodiment, an easy-adhesive layer 30 has a bilayer structure in which a first layer 31 and a second layer 32 are integrated.

### First Layer

The first layer 31 (hereinafter, sometimes referred to as "first easy-adhesive layer") that constitutes a part of the easy-adhesive layer 30 is provided on one side of a support, and contains an inorganic fine particle and a binder containing an acrylic resin crosslinked by an oxazoline compound.
The binder containing an acrylic resin crosslinked by an oxazoline compound, and the inorganic fine particle, which are included in the first easy-adhesive layer 31, are the same as those contained in the easy-adhesive layer 22 used for the first exemplary embodiment.
In the case of using such a first easy-adhesive layer 31, adhesive properties with respect to the support 21 are excellent, and reduction in the adhesive properties can be suppressed effectively even if the easy-adhesive layer has been exposed to an environment of heat and humidity.
The thickness of the first easy-adhesive layer 31. is preferably from 0.03 µm to 1 µm, and more preferably from 0.05 µm to 0.8 µm.

### Second Layer

The second layer 32 (hereinafter, sometimes referred to as "second easy-adhesive layer") that constitutes a part of the easy-adhesive layer 30 is provided on the first easy-adhesive layer 31, and is configured to include a second polymer. By disposing the second easy-adhesive layer 32 on the first easy-adhesive layer 31, the inorganic fine particles contained in the first easy-adhesive layer 31 can be prevented from falling off.
The second polymer incorporated in the second easy-adhesive layer 32 is preferably a polyolefin resin or an acrylic resin, from the viewpoint of adhesion to an adhesive agent. It is preferable that the second easy-adhesive layer 32 is configured to include a second polymer (preferably, a polyolefin resin or an acrylic resin) that is crosslinked by a crosslinking agent such as an oxazoline compound, a carbodiimide compound, or an epoxy compound, substantially similar to the components except the inorganic fine particle in the first easy-adhesive layer 31. However, the second polymer is not necessarily crosslinked by a crosslinking agent.
Further, the second easy-adhesive layer 32 may also contain inorganic fine particles. However, from the viewpoint of preventing the inorganic fine particles from falling off, it is preferable that the second easy-adhesive layer 32 does not contain inorganic fine particles.
The thickness of the second easy-adhesive layer 32 is preferably from 0.02 µm to 0.6 µm, and more preferably from 0.04 µm to 0.3 µm.

The thickness of the whole easy-adhesive layer 30 is preferably in a range of from 0.03 µm to 1 µm, which is the same as the thickness of the easy-adhesive layer 22 in the first exemplary embodiment. Further, the ratio (T2/T1) of the thickness T2 of the second easy-adhesive layer 32 relative to the thickness T1 of the first easy-adhesive layer 31. is preferably in a range of from about 1/5 to about 1/1. When this ratio is 1/1 or lower, namely, when the second easy-adhesive layer 32 is thinner than the first easy-adhesive layer 31, the adhesive property of the easy-adhesive layer when placed under an environment of heat and humidity may further be enhanced. When the ratio is 1/5 or higher, the falling-off of the inorganic fine particle 25 may be prevented more certainly.

### Manufacturing Method

The method of manufacturing the back sheet base material film 14 of the present invention is not particularly limited, but preferably, the back sheet base material film 14 can be manufactured by a method including: coating a liquid containing a compound having an oxazoline group, an acrylic resin, and an inorganic particle on at least one side of a sheet-shaped support containing a first polymer to form a coating film; and heating the coating film such that the acrylic resin is crosslinked by the compound containing an oxazoline group.

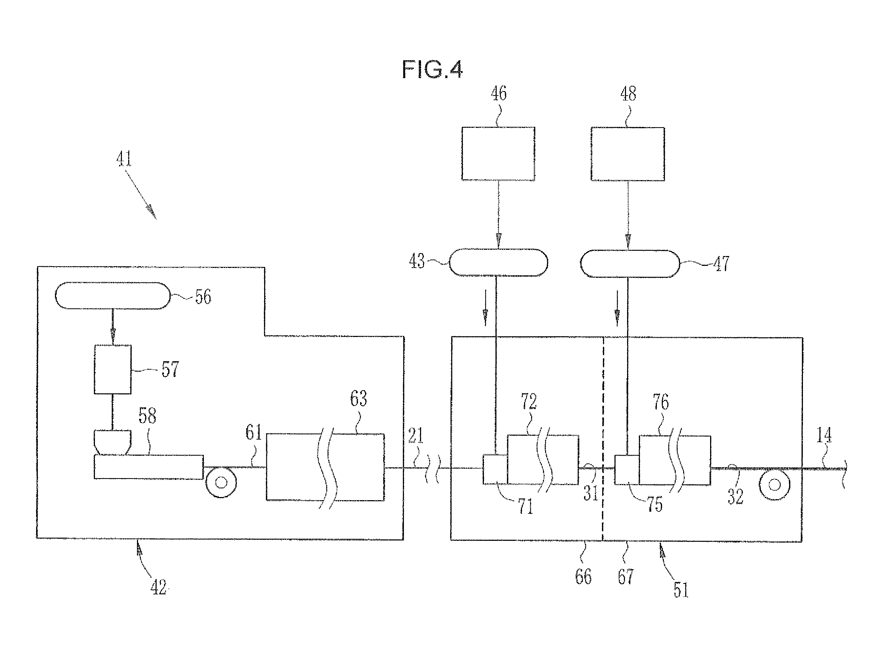

For example, the back sheet base material film of the present invention may be manufactured by use of the manufacturing equipment 41 having a configuration as shown in Fig. 4. The equipment 41 is equipped with a support manufacturing unit 42 that manufactures the support 21, a first coating liquid manufacturing unit 46 that prepares a first coating liquid 43 for forming the first easy-adhesive layer 31, a second coating liquid manufacturing unit 48 that manufactures a second coating liquid 47 that is coated on the first easy-adhesive layer 31 to form the second easy-adhesive layer 32, and an easy-adhesive layer forming unit 51 that forms the easy-adhesive layer 30 on the support 21. Further, in a case in which a barrier sheet 23 is further provided on the support 21, a barrier sheet forming unit (not shown) is provided at the downstream side of the easy-adhesive layer forming unit 51. Note that, the easy-adhesive layer forming unit 51 and the barrier sheet forming unit may not be a successive, so-called, on-line system, and may be a so-called off-line system such that the support 21 on which the easy-adhesive layer 30 has been formed is wound up in a roll for a moment, and the support is pulled out from the roll to take the support to the barrier sheet forming unit.

In the support manufacturing unit 42, a raw material of the support 21, for example, a first polymer 56 in the pellet form, is introduced into a drying machine 57 and is dried, and then the resulting pellet is taken to the melt-extruding machine 58 and is extruded in the form of a film by using this melt-extruding machine 58. Hereinafter, this polymer compound in the form of a film is referred to as a base raw material 61. This base raw material 61 is taken to a stretching machine 63.

The stretching machine 63 is provided with a temperature adjusting machine (not shown) that adjusts a temperature of the base raw material 61 to a predetermined temperature. By using the temperature adjusting machine, the temperature of the base raw material 61 is raised or lowered to a predetermined temperature with a predetermined timing, while the base raw material is being conveyed.

The stretching machine 63 conducts an stretching process of applying tension in a predetermined direction while conveying the base raw material 61. In the stretching process, a longitudinal direction stretching process of stretching the base raw material 61 in the longitudinal direction and a cross direction stretching process of stretching the base raw material 61 in the cross direction to extend the width are carried out, and further, after the cross direction stretching process, a heating process of heating the base raw material 61 is carried out. By carrying out the above processes using the stretching machine 63, a support 21 is obtained from the base raw material 61.

The first coating liquid 43 which is manufactured in the first coating liquid manufacturing unit 46 is conveyed to a first easy-adhesive layer forming device 66 in the easy-adhesive layer forming unit 51.

The support 21 which is obtained by the film formation in the support manufacturing unit 42 is successively taken to the first easy-adhesive layer forming device 66 in the easy-adhesive layer forming unit 51, and the first easy-adhesive layer 31 is formed. The first easy-adhesive layer forming device 66 is equipped with a coating machine 71 that coats the first coating liquid 43 on the support 21, and a heating machine 72 that dries the first coating liquid 43 on the support 21. By using this first easy-adhesive layer forming device 66, a coating film of the first coating liquid 43 is formed on the support 21, while the support is being conveyed, and the coating film is dried by using the heating machine 72, to form a first easy-adhesive layer 31.

The support 21 on which the first easy-adhesive layer 31 is formed is successively taken to the second easy-adhesive layer forming unit 67. The second easy-adhesive layer forming unit 67 is equipped with a coating machine 75 that coats the second coating liquid 47 manufactured in the second coating liquid manufacturing unit 48 on the first easy-adhesive layer 31. formed on the support 21, and a heating machine 76 that dries by heating the second coating liquid 47. In this second easy-adhesive layer forming unit 67, the second coating liquid 47 is coated on the support 21, while the support is being conveyed, and the coating film is dried by heating using the heating machine 76, to form a second easy-adhesive layer 32.

In a case in which the first coating liquid and the second coating liquid each contain an oxazoline compound and an acrylic resin, by heating with the heating machine 72 and the heating machine 76, each coating film is dried, the solvent is removed, and the oxazoline compound reacts with the acrylic resin to crosslink the acrylic resin.
Note that, in the case of forming an easy-adhesive layer 22 in place of the easy-adhesive layer 30, the second easy-adhesive layer forming unit 67 is unnecessary.

The methods of forming the first easy-adhesive layer 31 and the second easy-adhesive layer 32 are not particularly limited, and the first easy-adhesive layer 31 and the second easy-adhesive layer 32 may be coated by selecting a known coating machine as appropriate according to the purposes. Examples include coating using a spin coater, a roll coater, a bar coater, or a curtain coater.

Regarding the drying by heating of the coated first coating liquid 43 and second coating liquid 47, each coating film is heated using the heating machine 72 or 76 such that each coating film is heated to at least 100°C, namely, to a temperature of 100°C or higher, and more preferably to a temperature of 130°C or higher.

By going through such processes, an easy-adhesive layer 30 having a bilayer structure is formed on the support. When the acrylic resin is crosslinked by the oxazoline compound by heating after the coating films have been provided through coating of the coating liquids, the polyester film of the support heat-shrinks. Owing to this heating, the support, is heat-shrunk to a certain extent, and therefore, heat-shrinkage at the time of usage can be suppressed when the support is used as one part of the back sheet of a solar cell. For example, by using a PET film as the support and performing heating at a temperature of from 310°C to 190°C for 0.3 minutes to 5 minutes in the heating process at a time when the acrylic resin is crosslinked to form the easy-adhesive layer, a back sheet base material film having a heat-shrinkage ratio in an in-plane direction of 0.5% or less when the base material film is heated at 150°C for 30 minutes can be obtained.
According to aspects of the present invention, there are provided, for example, the following base material films for a back sheet of a solar cell and a method of manufacturing a base material film for a back sheet of a solar cell.
<1> A base material film for a back sheet of a solar cell, the base material film including:
   a sheet-shaped support containing a first polymer; and
   an easy-adhesive layer provided on at least one side of the support, the easy-adhesive layer including an inorganic fine particle and a binder containing an acrylic resin crosslinked by a compound having an oxazoline group.
<2> The base material film for a back sheet of a solar cell according to the item <1>, wherein the first polymer comprises a polyester.
<3> The base material film for a back sheet of a solar cell according to the item <1> or <2>, wherein a content of a structural moiety derived from the compound having the oxazoline group in the easy-adhesive layer is from 5% by mass to 50% by mass, with respect to a structural moiety derived from the acrylic resin.
<4> The base material film for a back sheet of a solar cell according to any one of the items <1> to <3>, wherein a content of the inorganic fine particle in the easy-adhesive layer is from 20% by volume to 120% by volume with respect to the binder.
<5> The base material film for a back sheet of a solar cell according to any one of the items <1> to <4>, wherein a primary particle diameter of the inorganic fine particle is from 10 nm to 300 nm.
<6> The base material film for a back sheet of a solar cell according to any one of the items <1> to <5>, wherein the easy-adhesive layer is provided on at least one side of the support, the easy-adhesive layer including a first layer containing the inorganic fine particle and the binder including the acrylic resin crosslinked by the compound having the oxazoline group, and a second layer provided on the first layer, the second layer including a second polymer.
<7> The base material film for a back sheet of a solar cell according to the item <6>, wherein the second polymer includes a polyolefin resin or an acrylic resin.
<8> The base material film for a back sheet of a solar cell according to any one of the items <1> to <7>, wherein a heat shrinkage ratio in an in-plane direction is 0.5% or less, when the base material film is heated at 150°C for 30 minutes.
<9> A method of manufacturing a base material film for a back sheet of a solar cell, the method including:
   coating a liquid including a compound having an oxazoline group, an acrylic resin, and an inorganic fine particle on at least one side of a sheet-shaped support containing a first polymer to form a coating film; and
   heating the coating film such that the acrylic resin is crosslinked by the compound having the oxazoline group.

### EXAMPLES

In the following, the examples will be described, but it should be construed that the present invention is not limited to these examples.

Example 1 A support of a base material film for a back sheet of a solar cell was formed according to the following procedure. First, a polyethylene terephthalate (PET) resin having an intrinsic viscosity of 0.66, which was prepared by polycondensation using Ti (titanium) as a catalyst was dried so as to have a moisture content of 50 ppm or less, and then the resulting PET resin was melted in an extruder in which the heater temperature was set at a range of from 280°C to 300°C.
The melted PET resin was discharged from a die portion onto a chilled roll charged with static electricity, thereby obtaining an amorphous base. The amorphous base thus obtained was stretched in the base proceeding direction so as to be stretched 3.3 times its length, and then was stretched in the cross direction so as to be stretched 3.8 times in width to obtain a support having a thickness of 210 µm.

The support having a thickness of 21.0 µm formed as described above was conveyed at a conveyance speed of 105 m/min, and both sides of the support were subjected to a corona discharge treatment under the condition of 730 J/m². Thereafter, the first layer coating liquid (1) described below was coated by a bar coating method so that the dry weight was 233 mg/m². Then, this was dried at 180°C for 1 minute to form a first layer. Subsequently, on the first layer, the second layer coating liquid (1) described below was coated by a bar coating method so that the dry weight was 65.9 mg/m², and was dried at 170°C for 1 minute. In this way, a base material film for a back sheet of a solar cell, in which the first layer and the second layer were laminated on one side of the support, was obtained.
The obtained base material film was heated at 150°C for 30 minutes, and it was revealed that the heat-shrinkage ratio of the in-plane direction (MD direction (machine direction)) was 0.27%.

### First Layer Coating Liquid (1)

| | |
|---|---|
| Polyacrylic binder | 19.1 parts by mass |
| (trade name: JURYMER ET-410, manufactured by TOAGOSEI CO., LTD.; solid content 30%) | |
| Oxazoline compound | 7.1 parts by mass |
| (trade name: EPOCROS WS700, manufactured by NIPPON SHOKUBAI CO., LTD.; solid content 25%) | |
| Surfactant A | 62.0 parts by mass |
| (a 1% aqueous solution of NAROACTY CL-95 (trade name, manufactured by Sanyo Chemical Industries, Ltd.)) | |
| Inorganic filler | 123.4 parts by mass |
| (a 20% aqueous solution of tin oxide fine particles S2000 (trade name, manufactured by Mitsubishi Materials Corporation)) | |
| Distilled water | added to make 1000 parts by mass in total |

### Second Layer Coating Liquid (1)

| | |
|---|---|
| Polyethylene binder | 26.2 parts by mass |
| (trade name: CHEMIPEARL S75N, manufactured by Mitsui Chemicals, Inc., solid content 24%) | |
| Epoxy compound | 221.8 parts by mass |
| (trade name: DENACOL EX-614B, manufactured by Nagase ChemteX Corporation; solid content 1%) | |
| Surfactant A | 77.2 parts by mass |
| (a 1% aqueous solution of NAROACTY CL-95 (trade name, manufactured by Sanyo Chemical Industries, Ltd.)) | |
| Distilled water | added to make 1000 parts by mass in total |

Example 2 On the PET film subjected to the corona discharge treatment described above, the first layer coating liquid (2) described below was coated by a bar coating method so that the dry weight was 145.4 mg/m². Then, this was dried at 180°C for 1 minute to form a first layer. Subsequently, on the first layer, the second layer coating liquid (2) described below was coated by a bar coating method so that the dry weight was 63.2 mg/m², and was dried at 170°C for 1 minute. In this way, a base material film for a back sheet of a solar cell, in which the first layer and the second layer were laminated on one side of the support, was obtained.
The obtained base material film was heated at 150°C for 30 minutes, and it was revealed that the heat-shrinkage ratio of the in-plane direction (MD direction) was 0.26%.

### First Layer Coating Liquid (2)

| | |
|---|---|
| Polyacrylic binder | 19.1 parts by mass |
| (trade name: JURYMER ET-410, manufactured by TOAGOSEI CO., LTD.; solid content 30%) | |
| Oxazoline compound | 7.1 parts by mass |
| (trade name: EPOCROS WS700, manufactured by NIPPON SHOKUBAI CO., LTD.; solid content 25%) | |
| Surfactant A | 62.0 parts by mass |
| (a 1% aqueous solution of NAROACTY CL-95 (trade name, manufactured by Sanyo Chemical Industries, Ltd.)) | |
| Inorganic filler | 61.7 parts by mass |
| (a 20% aqueous solution of tin oxide fine particles S2000 (trade name, manufactured by Mitsubishi Materials Corporation)) | |
| Distilled water | added to make 1000 parts by mass in total |

### Second Layer Coating Liquid (2)

| | |
|---|---|
| Polyacrylic binder | 21.0 parts by mass |
| (trade name: JURYMER ET-410. manufactured by TOAGOSEI CO., LTD.; solid content 30%) | |
| Epoxy compound | 221.8 parts by mass |
| (trade name: DENACOL EX-614B, manufactured by Nagase ChemteX Corporation; solid content 1 %) | |
| Surfactant A | 38.6 parts by mass |
| (a 1% aqueous solution of NAROACTY CL-95 (trade name, manufactured by Sanyo Chemical Industries, Ltd.)) | |
| Distilled water | added to make 1000 parts by mass in total |

### Comparative Example 1

Preparation of a base material film for a back sheet of a solar cell was conducted in the same manner as in Example 1, except that the first layer coating liquid in Example 1 was changed as follows, and the second layer was not provided.

### First Layer Coating Liquid (C1)

| | |
|---|---|
| Polyurethane binder | 15.5 parts by mass |
| (trade name: OLESTAR UD-350, manufactured by Mitsui Chemicals, Inc.; solid content 38%) | |
| Oxazoline compound | 7.1 parts by mass |
| (trade name: EPOCROS WS700, manufactured by NIPPON SHOKUBAI CO., LTD.; solid content 25%) | |
| Surfactant A | 62.0 parts by mass |
| (a 1% aqueous solution of NAROACTY CL-95 (trade name, manufactured by Sanyo Chemical Industries, Ltd.)) | |
| Inorganic filler | 123.4 parts by mass |
| (a 20% aqueous solution of tin oxide fine particles S2000 (trade same, manufactured by Mitsubishi Materials Corporation)) | |
| Distilled water | added to make 1000 parts by mass in total |

### Comparative Example 2

Preparation of a base material film for a back sheet of a solar cell was conducted in the same manner as in Example 1, except that the first layer coating liquid and the second layer coating liquid in Example 1 were each changed as follows.

### First Layer Coating Liquid (C2)

| | |
|---|---|
| Polyurethane binder | 18.0 parts by mass |
| (trade name: OLESTAR UD-350, manufactured by Mitsui Chemicals, Inc.; solid content 38%) | |
| Oxazoline compound | 7.1 parts by mass |
| (trade name: EPOCROS WS700, manufactured by NIPPON SHOKUBAI CO., LTD.; solid content 25%) | |
| Surfactant A | 62.0 parts by mass |
| (a 1% aqueous solution ofNAROACTY CL-95 (trade name, manufactured by Sanyo Chemical Industries, Ltd.)) | |
| Inorganic filler | 61.7 parts by mass |
| (a 20% aqueous solution of tin oxide fine particles S2000 (trade name, manufactured by Mitsubishi Materials Corporation)) | |
| Distilled water | added to make 1000 parts by mass in total |

### Second Layer Coating Liquid (C2)

| | |
|---|---|
| Polyacrylic binder | 21.0 parts by mass |
| (trade name: JURYMER ET-41 0, manufactured by TOAGOSEI CO., LTD.; solid content 30%) | |
| Epoxy compound | 221.8 parts by mass |
| (trade name: DENACOL EX-614B, manufactured by Nagase ChemteX Corporation; solid content 1%) | |
| Surfactant A | 38.6 parts by mass |
| (a 1% aqueous solution of NAROACTY CL-95 (trade name, manufactured by Sanyo Chemical Industries, Ltd.)) | |
| Distilled water | added to make 1000 parts by mass in total |

**TABLE 1**

| | | Easy-Adhesive Layer | | | | | | | |
|---|---|---|---|---|---|---|---|---|---|
| | Support | First Layer | | | | | | Second Layer | |
| | | Oxazoline Compound | | Fine Particle | | Polymer (Acrylic Resin in Examples 1 and 2) | | Crosslinking Agent | Polymer |
| | | Type | vs. Polymer (% by mass) | Type | vs. Binder (% by volume) | Type | vs. Total Mass of Solids (% by mass) | | |
| Example 1 | PET | WS700 | 31 | SnO₂ | 47 | ET-410 | 17 | Epoxy | S75N |
| Example 2 | PET | WS700 | 31 | SnO₂ | 24 | ET-410 | 28 | Epoxy | ET-410 |
| Comparative Example 1 | PET | WS700 | 30 | SnO₂ | 46 | UD-350 | 18 | - | - |
| Comparative Example 2 | PET | WS700 | 26 | SnO₂ | 22 | UD-350 | 33 | Epoxy | ET-410 |

### Evaluation

With regard to the obtained back sheet base material films, evaluation of adhesive strength with respect to EVA and evaluation of the degree of falling-off of the inorganic fine particles were conducted.

### Adhesive Strength with respect to EVA

Evaluation of the adhesive strength was performed with regard to a back sheet base material film that had not yet exposed to an environment of heat and humidity, and a back sheet base material film that had exposed to an environment of heat and humidity. Regarding the former, the results are shown in "A" column in Table 2 below, and regarding the latter, the results are shown in "B" column. The expression "had exposed to an environment of heat and humidity" as used herein means that the back sheet base material film had been exposed to an atmosphere of 105°C and relative humidity of 100%RH for 144 hours.

Evaluation of adhesive strength was performed according to the following method. First, from each of the obtained back sheet base material films, two sample pieces each having a length of 120 mm and a width of 50 mm were cut out. Hereinafter, the sample pieces thus prepared by cutting out are referred to as the back sheet base material film samples. A sheet of EVA (ethylene-vinyl acetate copolymer, ethylene : vinyl acetate = 70 : 30 (weight ratio)) having a length of 80 mm, a width of 20 mm, and a thickness of 500 µm was sandwiched between the two back sheet base material film samples, such that both of the supports of the two back sheet base material film samples were exposed to the outside, respectively, and the EVA sheet and the two back sheet base material film samples were adhered to each other by pressing for 3 minutes at 130°C. The pressing load was set at 3 kgf (= 3 × 9.8 N). Thereafter, the resulting substance was subjected to a heat treatment at 150°C for 30 minutes, so that the two back sheet base material film samples and the EVA plate were completely adhered to each other. The thus obtained substance obtained by adhering the two back sheet base material film samples and the EVA sheet is referred to as the EVA laminate sample in the following description.

The EVA laminate sample was cut into a stripe having a width of 8 mm. With regard to the EVA laminate sample thus prepared by cutting, a well-known T-type peeling test was performed as follows. The EVA laminate sample was pulled vertically in a manner such that the thickness direction became vertical and the two (top and bottom) back sheet base material film samples were pulled vertically at a speed of 10 mm/min. The peeling strength was successively measured, and the maximum value among the successively measured values was determined. This test was conducted with regard to three EVA laminate samples, and a maximum value was measured for each test. The average value of the three maximum values thus measured was defined as the adhesive strength between the back sheet base material film and EVA.

*Adhesive Property* Based on the adhesive strength thus obtained, the "adhesive property" was evaluated according to the following evaluation criteria. The grades 3 to 5 are practically acceptable.
5: The interface is not peeled, and the sample ruptures.
4: The peeling strength is 50 N or more.
3: The peeling strength is 20 N or more but less than 50 N.
2: The peeling strength is 5 N or more but less than 20 N.
1: The peeling strength is less than 5 N, or peeling occurs during the testing in an environment of heat and humidity.

*Falling-off of Inorganic Fine Particle* The degree of falling-off of the inorganic fine particles were evaluated according to the following method. A sample piece having a size of 5 cm × 5 cm was cut out from the obtained back sheet base material film. The back sheet base material film sample thus obtained by cutting out was placed on a black paper sheet, such that the exposed face of the easy-adhesive layer of the back sheet base material film sample was set downwards and the exposed face was in contact with the upper surface of the black paper sheet. Then, a load of 5 kgf (= 5 × 9.8 N) was loaded from the top. While keeping this state, the back sheet base material film sample was made to slide on the black paper sheet at a speed of 1 cm/sec. After the reciprocating slide of the back sheet base material film sample at the distance of 20 cm for 5 times, the black paper sheet and the surface of the easy-adhesive layer of the back sheet base material film sample were visually observed. The test was performed three times with regard to the same back sheet base material film, specifically, three back sheet base material film samples were prepared by cutting out from one back sheet base material film, and the test was performed with respect to these three back sheet base material film samples. An average value of these three tests was measured.

Based on the average value measured as described above, the degree of falling-off was evaluated according to the evaluation criteria described below. The grades 3 to 5 are practically acceptable. The evaluation results are shown in the column "Falling-Off of Inorganic Fine Particle" in Table 2. It should be noted that, in the following evaluation criteria, the scratches on the easy-adhesive layer were formed by the inorganic fine particles that had been dropped off from the easy-adhesive layer, and the degree of scratches relates to the degree of falling-off of the inorganic fine particles.
5: No change is observed on the black paper sheet and the surface of the easy-adhesive layer.
4: No change is observed on the black paper sheet, but extremely slight scratches are recognized at the surface of the easy-adhesive layer.
3: Extremely slight amount of inorganic fine particles that have been dropped off are seen on the black paper sheet, and slight scratches are recognized at the surface of the easy-adhesive layer.
2: Inorganic fine particles that have been dropped off are seen on the black paper sheet, and scratches are recognized at the surface of the easy-adhesive layer.
1: Inorganic fine particles that have been dropped off are clearly seen on the black paper sheet, and scratches are clearly recognized at the surface of the easy-adhesive layer.
The evaluation results are shown in Table 2.

**TABLE 2**

| | Adhesive Property | | Falling-Off of Inorganic Fine Particle |
|---|---|---|---|
| | A | B | |
| Example 1 | 5 | 5 | 4 |
| Example 2 | 5 | 4 | 5 |
| Comparative Example 1 | 4 | 1 | 3 |
| Comparative Example 2 | 4 | 0 | 4 |

Further, regarding the physical property values of the back sheet base material films obtained in Examples 1 and 2, the film thickness, heat shrinkage ratio, rupture stress, rupture elongation, and dielectric breakdown voltage were measured. The results are shown in Table 3.
Furthermore, with regard to the back sheet base material films in Examples and Comparative Examples, the adhesive strength when using an adhesive agent was evaluated. The evaluation results are shown in Table 4.

### Heat-Shrinkage Ratio

The heat-shrinkage ratio in the MD direction and the heat-shrinkage ratio in the TD direction (transverse direction) were measured. The measurement results are shown in Table 3. The heat shrinkage ratio was determined according to the following method. A sample having a size of 30 mm in the TD direction and 120 mm in the MD direction was cut out from the base material film. Two base lines were drawn precisely so that the space of the two base lines was 100 mm in the MD direction of the sample. Then, the sample was left in an oven heated at 170°C for 10 minutes without applying tension. Thereafter, the sample was cooled to room temperature, the space of the two base lines was measured, and this value was defined as L (unit: mm). The heat-shrinkage ratio in the MD direction was calculated from the following formula: 100 × (100 - L)/100. As another sampling, a sample having a size of 30 mm in the MD direction and 120 mm in the TD direction was cut out from the base material film, and measurement and calculation were performed in the same manner as those described above. The thus-obtained value was defined as a heat-shrinkage ratio in the TD.

### Rupture Stress and Rupture Elongation

A tensile test of the film was conducted using a tension universal tester (trade name: STROGRAPH VE50, manufactured by Toyo Seiki Seisaku-sho, Ltd.), and the stress and elongation at the breaking point were measured.

### Dielectric Breakdown Voltage

The dielectric breakdown voltage was measured according to the method prescribed in JIS C 2010. As the electrodes, a spherical electrode and a plate-like electrode were used in combination, and the dielectric breakdown voltage was measured in oil by a short-time breakdown method.

### Adhesive Strength due to Adhesive Agent

Evaluation of the adhesive strength due to an adhesive agent was conducted according to the following method. First, two sample pieces each having a length of 120 mm and a width of 50 mm were cut out from each of the obtained back sheet base material films. Hereinafter, the sample piece obtained by cutting out in such a manner is referred to as "a sample (A)". Further, films for the peeling test provided with an easy-adhesive layer were prepared in the same manner as that described above, except that the thickness of the base material film was changed to 120 µm in each Example. Two sample pieces each having a length of 120 mm and a width of 50 mm were cut out from each of the obtained films for the peeling test. Hereinafter, the sample piece obtained by cutting out in such a manner is referred to as "a sample (B)".
A urethane-isocyanate adhesive agent was coated on the surface of the easy-adhesive layer of the sample (A) to give a thickness of 5 µm, then the surface of the easy-adhesive layer of the sample (B) was laminated thereon, which was left at 40°C for 5 days to allow to cure and adhere, thereby obtaining an adhesion sample.

The adhesion sample was cut into a stripe having a width of 20 mm. With regard to the adhesion sample thus prepared by cutting, a well-known 180° peeling test was performed as follows. The two, up and down, back sheet base material film samples in the adhesion sample were each pulled in an opposite direction from each other at a speed of 100 mm/min. The peeling strength was successively measured, and the maximum value among the successively measured values was determined. This test was conducted with regard to three adhesion samples, and a maximum value was measured for each test. The average value of the three maximum values thus measured was defined as the adhesive strength between the back sheet base material film and the adhesive agent.

### Adhesive Property

Based on the adhesive strength thus obtained, the "adhesive property" was evaluated according to the following evaluation criteria. The grades 3 to 5 are practically acceptable.
5: The interface is not peeled, and the sample ruptures.
4: The peeling strength is 20 N or more.
3: The peeling strength is 16 N or more but less than 20 N.
2: The peeling strength is 10 N or more but less than 16 N.
1: The peeling strength is less than 10 N, or peeling occurs during the testing in an environment of heat and humidity.

The evaluation of the adhesive strength was performed with regard to a back sheet base material film that had not exposed to in an environment of heat and humidity, and a back sheet base material film that had exposed to in an environment of heat and humidity. Regarding the former, the results are shown in "A" column in Table 4 below, and regarding the latter, the results are shown in "B" column. The expression "had exposed to in an environment of heat and humidity" as used herein means that the back sheet base material film had been exposed to in the conditions of 105°C and relative humidity of 100%RH for 144 hours.

**TABLE 3**

| Evaluation Terms | | Examples 1 | Example 2 |
|---|---|---|---|
| Film Thickness (µm) | | from 200 to 218 | from 201 to 219 |
| Heat-Shrinkage Ratio (%) | MD | from 0.19 to 0.28 | from 0.17 to 0.29 |
| | TD | from -0.05 to 0.07 | from -0.07 to 0.07 |
| Rupture Stress (%) | MD | from 150 to 183 | from 147 to 179 |
| | TD | from 181 to 220 | from 160 to 212 |
| Rupture Elongation (%) | MD | from 122 to 181 | from 121 to 183 |
| | TD | from 90 to 138 | from 95 to 151 |
| Dielectric Breakdown Voltage (kV) | | from 14 to 20 | from 14 to 21 |

**TABLE 4**

| | Adhesive Property | |
|---|---|---|
| | A | B |
| Example 1 | 5 | 4 |
| Examples 2 | 4 | 3 |
| Comparative Example 1 | 4 | 1 |
| Comparative Example 2 | 4 | 1 |

All publications, patent applications, and technical standards mentioned in this specification are herein incorporated by reference to the same extent as if each individual publication, patent application, or technical standard was specifically and individually indicated to be incorporated by reference

## Claims

1. A base material film for a back sheet of a solar cell, the base material film comprising:
a sheet-shaped support comprising a first polymer; and
an adhesive layer provided on at least one side of the support, the adhesive layer comprising an inorganic fine particle and a binder comprising an acrylic resin crosslinked by a compound, having an oxazoline group.

2. The base material film for a back sheet of a solar cell according to claim 1, wherein the first polymer comprises polyester.

3. The base material film for a back sheet of a solar cell according to claim 1 or 2, wherein a content of a structural moiety derived from the compound having the oxazoline group in the adhesive layer is from 5% by mass to 50% by mass, with respect to a structural moiety derived from the acrylic resin.

4. The base material film for a back sheet of a solar cell according to any one of clams 1 to 3, wherein a content of the inorganic fine particle in the adhesive layer is from 20% by volume to 120% by volume with respect to the binder.

5. The base material film for a back sheet of a solar cell according to any one of claims 1 to 4, wherein a primary particle diameter of the inorganic fine particle is from 10 nm to 300 nm.

6. The base material film for a back sheet of a solar cell according to ant one of claims 1 to 5, wherein the adhesive layer is provided on at least one side of the support, the adhesive layer comprising a first layer comprising the inorganic fine particle and the binder comprising the acrylic resin crosslinked by the compound having the oxazoline group, and a second layer provided on the first layer, the second layer comprising a second polymer.

7. The base material film for a back sheet of a solar cell according to claim 6, wherein the second polymer comprises a polyolefin resin or an acrylic resin.

8. The base material film for a back sheet of a solar cell according to any one of claims 1 to 7, wherein a heat-shrinkage ratio in an in-plane direction is 0.5% or less, when the base material film is heated at 150°C for 30 minutes.

9. A method of manufacturing a base material film for a back sheet of a solar cell, the method comprising:
coating a liquid comprising a compound having an oxazoline group, an acrylic resin, and an inorganic fine particle on at least one side of a sheet-shaped support comprising a first polymer to form a coating film; and
heating the coating film such that the acrylic resin is crosslinked by the compound having the oxazoline group.
